Europäisches Patentamt

European Patent Office

Office européen des brevets

(11) Publication number: **0 162 468**
**A1**

(12) **EUROPEAN PATENT APPLICATION**

(21) Application number: **85106374.3**

(22) Date of filing: **23.05.85**

(51) Int. Cl.⁴: **H 01 J 37/30**
**H 01 L 21/26**

(30) Priority: **25.05.84 JP 104532/84**

(43) Date of publication of application:
**27.11.85 Bulletin 85/48**

(84) Designated Contracting States:
**DE FR GB**

(71) Applicant: **HITACHI, LTD.**
**6, Kanda Surugadai 4-chome Chiyoda-ku**
**Tokyo 100(JP)**

(72) Inventor: **Tamura, Hifumi**
**10-8, Kiyokawa-cho**
**Hachioji-shi Tokyo(JP)**

(72) Inventor: **Hosaka, Sumio**
**2196-657, Hirai Hinodemachi**
**Nishitama-gun Tokyo(JP)**

(72) Inventor: **Ishitani, Tohru**
**R304, Seibu-Sayamadai-Haitu 1354-56, Irumagawa**
**Sayama-shi Saitama-ken(JP)**

(72) Inventor: **Umemura, Kaoru**
**B205, Hitachi-Dai4-Kyoshin-ryo 4-14-6**
**Nishikoigakubo Kokubunji-shi Tokyo(JP)**

(72) Inventor: **Kawanami, Yoshimi**
**4-1-2, Hiyoshi-cho**
**Kokubunji-shi Tokyo(JP)**

(74) Representative: **Strehl, Schübel-Hopf, Schulz**
**Widenmayerstrasse 17 Postfach 22 03 45**
**D-8000 München 22(DE)**

(54) Ion microbeam implanter.

(57) An ion microbeam implanter includes a charged particle source (1) capable of providing both positive and negative charged particles, a condenser aperture (2), a condenser lens (3), an object lens (5), an object lens aperture (4), a blanking electrode (6), an ion beam deflection electrode (7), a field deflection electrode (8), and a charged particle acceleration power source (10). The deflection electrode (7) is an electrostatic deflection electrode. The ion beam and the electron beam are radiated on a sample (9) either simultaneously or in time sequence.

FIG. 1

EP 0 162 468 A1

ION MICROBEAM IMPLANTER

BACKGROUND OF THE INVENTION

This invention relates generally to an ion microbeam implanter. More particularly, the present invention relates to an ion microbeam implanter which effects local ion implanter and local heat-treatment to activate locally a dosed element, that is, which effects simultaneously the local ion implantation and the heat-treatment.

A conventional apparatus for implanting an ion microbeam generally consists of an ion source, a focusing system for the ion beam, a deflection system, a blanking device and a beam operating system, and uses only positive ions as primary charged particles, but does not extract electrons either simultaneously or in a time sequence. In other words, the conventional method does not particularly use heat-treating means, and the activation of dosed elements is effected either by utilizing a heating effect by heating the primary ion beam itself or by using separate heating means.

The prior art system described above involves the following problems.

The method which utilizes the heating effect of the primary ion beam itself is not free from the problem that the heat application conditions can not be changed arbitrarily and the optimal condiction cannot be changed easily or cannot be changed at all. The method which conducts heat-treatment after the ion implantation has the following various problems.

1) Heating of the sample for activation must be carried out by a separate step, so that the number of steps and hence, the cost, increase.

2) Since heat-treatment is made for a wafer as a whole, unnecessary portions are also heated so that adverse influences upon the peripheral portions are great. In addition, the peripheral diffusion becomes so vigorous that a dosed region due to activation expands more greatly than the dosed region, and the miniaturization of the device to be fabricated is hindered.

## SUMMARY OF THE INVENTION

The present invention is directed to provide an ion microbeam implanter which, when ion implantation is made locally by radiating a micro-ion beam of an impurity element to a semiconductor sample, superposedly radiates an electron beam either simultaneously or in a time sequence in order to conduct heat-treatment substantially simultaneously.

Ion micro-beam implantation is directed to form a dosed region of a fine impurity element. This object cannot be accomplished if the dosed region which is formed with much trouble by the microbeam implantation is diffused and expands laterally at an activation stage (heat-treatment stage). The present invention is motivated so as to obviate this problem. Extraction of ion and electron beams is made by changing pulse-wise the polarity of a liquid metal ion source.

### Brief Description of the Drawings

Figure 1 is a schematic view showing an ion microbeam implanter in accordance with the present invention; and

Figure 2 is a square wave diagram as an example of charged particle acceleration voltage waveforms in an ion source in the apparatus shown in Figure 1.

### DESCRIPTION OF THE PREFERRED EMBODIMENT

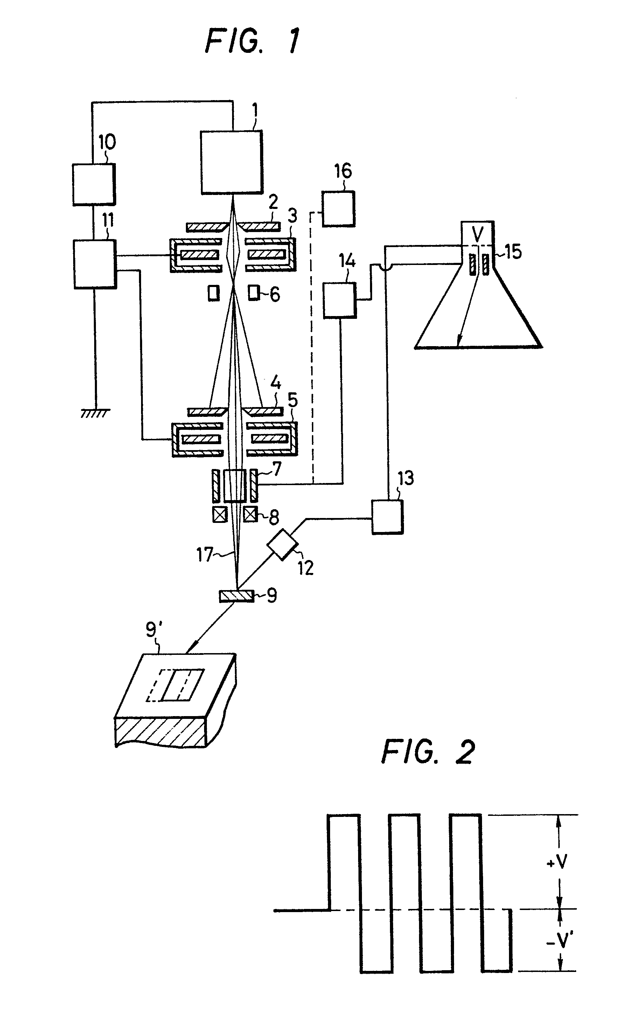

Figure 1 shows an embodiment of the present invention. The apparatus consists of a charged particle source 1 from which positive and negative charged particles can be extracted, a condenser aperture 2, a condenser lens 3, an object lens aperture 4, an object lens 5, a blanking electrode 6, an ion beam deflection electrode 7, a field deflection electrode 8, a sample 9, a charge particle acceleration power source 10, a divider 11, a secondary charged particle detector 12, an amplifier 13, a scanning power source 14, a CRT 15 and a CPU control system 16.

The functions of the principal portions are as follows. Either of the duo-plasmatron ion source and liquid metal ion source can be used as the positive and negative charged particle source 1. The charged particle acceleration power source 10 must extract both electrons having a negative charge and positive ions, and can generate positive and negative alternating voltages (a square wave voltage is shown in the drawing) whose zero level can be freely changed. The electron beam and the ion beam are alternately extracted using this power source 10. The lens power source 11 plays the role of supplying a voltage for focusing both charged beams on the sample 9. This main voltage is supplied from the charged particle acceleration power source 10, and is applied to the lens electrodes 3 and 5 after it is divided appropriately, in order to adjust the lens intensity. The deflection electrode 7 deflects the charged particle beam 17 in synchronism with the image observation CRT 15, and deflects or scans the beam on the sample 9 or 9'. In this case, an electrostatic deflection system in which the deflection quantity of the beam does not depend on the mass number is employed, so that the electron beam and the ion beam (irrespective of the ion seeds) 17 can be scanned under exactly the same condition.

The field deflection electrode 8 is the portion that plays a significant role in the present invention. It can change independently the deflection quantities of the electron and ion beams by utilizing the magnetic field exhibiting the mass dependency of deflection quantity. Therefore, both charged beams can scan the sample while their positions are being deviated from one another by a predetermined distance.

The principle of operation of the present invention is as follows. First of all, positive and negative a.c. voltages (square wave, trapezoidal wave, sine wave, or the like) are applied to the charged particle source(using a duo-plasmatron or a liquid metal ion source) 1 in order to extract the electron beam and the ion beam. Next, both charged beams 17 are focused on the sample using the lenses 3 and 5. Figure 2 shows an example of the impressed voltage to be applied to the ion source. In this case, the radiation positions of the electron and ion beams on the sample are deviated from each other by an arbitrary distance.

Under this state, both charged particle beams 17 are scanned by an arbitrary quantity at an arbitrary position on the sample by the electrostatic deflection electrode 7. In this case, it is possible to let the electron beam go ahead of the ion beam or vice versa in the scanning direction, by changing the direction of the deflection field. The deflection quantity can also be changed arbitrarily by changing the intensity of the magnetic field. Their displacement quantity can be measured by forming the scanning images of both charged particle beams on the CRT 15 and then determining the image deviation quantity. Furthermore, pattern scanning of the ion beam is effected by use of the CPU control system 16.

Next, an example is given in which a high resistivity region is formed in an integrated circuit in accordance with the present invention. An n-type substrate into which As is dosed in a dose of $5 \times 10^{17}/cm^3$ is used as the sample. Ion beam radiation is made under the condition of a 0.5 $\mu$m beam diameter, a current density of 0.4 A/cm$^2$, energy of 20 KeV and a dose of $4 \times 10^{17}/cm^3$. Electron beam radiation is made under the condition of a 0.5 $\mu$m beam diameter, a current density of 10 A/cm$^2$ and energy of 15 KeV.

Line scanning is made once while the electron beam is ahead of the ion beam. The activity of the high resistivity region thus formed is measured. It is found that at least about 90% is activated. Expansion in the lateral direction due to diffusion is limited to about 20%, the value being extremely smaller than the value obtained by the conventional heat-treating method which heats a wafer as a whole. It is thus evidenced that a high resistivity region of a sub-micron order can be formed, and this technique will be a break-through to the miniaturization of integrated circuit devices.

The present invention provides the following effects in fabrication of various miniature devices.

1) Miniature region ion implantation and heat-treatment can be made substantially simultaneously, and the fabrication process of devices can be simplified.

2) A heat-treatment region can be limited to a local region (ion implantation region) and heating temperature can be controlled easily. As a result, expansion of the injection layer due to diffusion can be restricted, and the miniaturization of functional devices can be accomplished.

3) Pre-heating treatment and post-heating treatment can be selected freely by changing the direction of deflection field.

4) Heating temperature can be changed arbitrarily for each local region.

CLAIMS:

1. An ion microbeam implanter including

a charged particle source (1) from which to extract electron and ion beams,

a deflection system (7, 8) for deflecting or scanning the charged particle beam extracted from said source (1), and an acceleration power source for impressing a voltage to said charged particle source (1) and accelerating said charged particles,

wherein said electron and ion beams from said charged particle source (1) are radiated either simultaneously or in time sequence to a sample (9).

2. An ion microbeam implanter according to claim 1 wherein an electrostatic deflection electrode (7) is used as said charged beam deflection system so as to radiate both of said electron and ion beams to said sample (9) in time sequence.

3. An ion microbeam implanter including

a charged particle source (1) from which to extract electron and ion beams,

a focusing lens system (3, 5) for converging the charged particle beam thus extracted,

a deflection system (7, 8) for deflecting or scanning said charged particle beam,

a blanking electrode (6) for turning on and off said charged particle beam on a sample (9),

a power source (10, 14) for said members (1-9), positive and negative alternating voltages being used as charged particle beam acceleration voltage and lens voltage, and

a field deflection electrode (7) disposed in the path of said charged particle beam,

wherein the quantities of deflection of said ion and electron beams are changed so that the relative radiation positions of both of said beams can be changed arbitrarily.

4.   An ion microbeam implanter according to claim 3 wherein said positive and negative alternating voltages can be set independently and arbitrarily.

PS/bi

*FIG. 1*

*FIG. 2*

| | DOCUMENTS CONSIDERED TO BE RELEVANT | | EP 85106374.3 |
|---|---|---|---|

| Category | Citation of document with indication where appropriate, of relevant passages | Relevant to claim | CLASSIFICATION OF THE APPLICATION (Int Cl 4) |
|---|---|---|---|
| X | EP - A2 - 0 084 850 (HITACHI) | 1 | H 01 J 37/30 |
| A | * Fig. 2; page 8, line 19 - page 9, line 14; page 9, line 25 - page 10, line 14 * | 3 | H 01 L 21/26 |
| | -- | | |
| A | EP - A2 - 0 075 949 (HITACHI) | 1,3 | |
| | * Fig. 3; page 5, line 6 - page 6, line 11; page 8, line 13 - page 9, line 7; page 12, line 26 - page 13, line 23 * | | |
| | -- | | |
| A | FR - A1 - 2 371 772 (HITACHI) | 1,3 | |
| | * Fig. 1; page 1, line 10 - page 2, line 6 * | | |
| | -- | | TECHNICAL FIELDS SEARCHED (Int. Cl 4) |
| A | PATENT ABSTRACTS OF JAPAN, unexamined applications, E section, vol. 8, no. 74, April 6, 1984 THE PATENT OFFICE JAPANESE GOVERNMENT page 144 E 236 * Kokai-no. 58-223 248 (TOKYO SHIBAURA DENKI) * | 1,3 | H 01 J 37/00 H 01 J 3/00 H 01 L 21/00 |
| | ---- | | |

The present search report has been drawn up for all claims

| Place of search | Date of completion of the search | Examiner |
|---|---|---|
| VIENNA | 05-08-1985 | BRUNNER |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82